# EUROPEAN PATENT APPLICATION

(11) **EP 1 180 728 A2**
(43) Date of publication of application: **20.02.2002**
(21) Application number: 01118854.7
(22) Date of filing: 14.08.2001
(51) Int. Cl.: G03G 13/26

(54) **Quality control method for planographic printing plate**

(30) Priority: 14.08.2000 JP 2000245481
(71) Applicant: Fuji Photo Film Co., Ltd., Kanagawa-ken (JP)
(72) Inventor: Aono, Koichiro, Yoshida-cho, Haibara-gun, Shizuoka-ken (JP); Kawauchi, Ikuo, Yoshida-cho, Haibara-gun, Shizuoka-ken (JP); Okuno, Kei, Yoshida-cho, Haibara-gun, Shizuoka-ken (JP)
(74) Representative: HOFFMANN - EITLE

(57) **Abstract**

The present invention is a quality control method for a planographic printing plate produced by subjecting an image forming material to a development processing with an alkaline developer, the method comprising the steps of: (A) preparing a standard alkaline developer and determining the activity of the standard alkaline developer by using a predetermined index; (B) measuring the activity of an alkaline developer to be evaluated by using the above-mentioned index; and (C) comparing the activity of the alkaline developer to be evaluated with that of the standard alkaline developer, and when the difference between the activities of the two developers exceeds a predetermined value, adjusting in accordance with the difference the value selected from the electric conductivity of the alkaline developer to be evaluated, the product of electric conductivity and temperature, and the product of electric conductivity and development processing time.

## Description

### BACKGROUND OF THE INVENTION

### Field of the Invention

The present invention relates to a method of controlling quality of a positive planographic printing plate for an infrared laser and for so-called direct plate production in which a plate can be directly made by scanning an infrared laser based on digital signals from a computer or the like. The positive planographic printing plate can be used as an offset printing master.

### Description of the Related Art

Development of lasers in recent years has been remarkable. In particular, high-output, compact solid-state lasers and semiconductor lasers having an emission range in the near infrared to infrared range are being developed. Accordingly, these lasers are very useful as an exposure light source at the time a printing plate is made directly on the basis of digital data from a computer or the like.

A positive planographic printing plate material for an infrared laser, for which the laser having an emission range in the infrared range is used as an exposure source, has an alkaline water-soluble binder resin, an IR dye which absorbs light and generates heat, and the like as the essential components.

When the positive planographic printing plate material for an infrared laser is subjected to exposure with the infrared laser, in unexposed portions (i.e., image portions), due to the interaction with the binder resin, the IR dye and the like contained in the positive planographic printing plate material act as a dissolution inhibitor which substantially decreases the solubility of the binder resin. In exposed portions (i.e., non-image portions), on the other hand, since the IR dye and the like absorb light and generate heat, the interaction between the IR dye and the like and the binder resin becomes weak. Therefore, at the time of development, the exposed portions (i.e., the image portions) are dissolved in an alkaline developer, thereby forming a planographic printing plate.

However, as compared with a positive planographic printing plate material which is formed by exposure with a UV, the latitude of activity of a developer is narrow for the positive planographic printing plate material for an infrared laser. Thus, problems arise in that densities of the image portions and plate wear resistance deteriorate when activity becomes high, and that inadequate development is easily caused when activity becomes low.

The above-described problems are caused by the essential difference in plate-making mechanisms between the positive planographic printing plate material for an infrared laser and the positive planographic printing plate material which is formed by exposure with a UV. This difference will be hereinafter described.

As the essential components, the material for the positive planographic printing plate formed by exposure with a UV includes an alkaline water-soluble binder resin, and onium salts or quinonediazide compounds. When the material for the positive planographic printing plate formed by exposure with a UV is exposed, similarly to the positive planographic printing plate material for an infrared laser, the onium salts or the quinonediazide compounds act as dissolution inhibitors in unexposed portions (i.e., image portions). However, in exposed portions (i.e., non-image portions), unlike in the positive planographic printing plate material for an infrared laser, the onium salts or the quinonediazide compounds are subjected to photodecomposition and thereby generate an acid, and act as dissolution accelerators for the binder resin. Therefore, in the material for the positive planographic printing plate formed by exposure with a UV, the difference in solubility in the alkaline developer between the exposed portions and the unexposed portions is very large.

In contrast, in the positive planographic printing plate material for an infrared laser, at the time of exposure, the interaction between the IR dye and the like and the binder resin becomes weak in the exposed portions (i.e., the non-image portions). However, since the IR dye does not act as a dissolution accelerator for the binder resin, the difference in solubility between the unexposed portions and the exposed portions is small.

In general, when the positive planographic printing plate for an infrared laser is subjected to development, an automatic developing machine which has a replenishing mechanism for maintaining the sensitivity of a developer as constant as possible is used. The replenishing mechanism serves to add a highly active replenishing solution to a developer in order to prevent a decrease in the pH of the developer due to the development processing of the plate and the developer absorbing CO₂, and thus to prevent deterioration in development performance. Specifically, in an ordinary processing system for presensitized plates, there have been already proposed a method in which electric conductivity is controlled and a replenishing solution is added so as to maintain a constant electric conductivity, and a method in which a predetermined amount of replenishing solution is periodically added whenever the number of plates subjected to a development processing reaches a certain value or after a certain period of time has elapsed. However, in the case of methods similar to conventional methods in which plate-making conditions for planographic printing plates having a wide latitude are controlled by electric conductivity, as the number of plates subjected to the development processing increases and large amounts of compositions contained in the photosensitive layers of the plates are dissolved in the developer, even if electric conductivity is the same as that at the beginning of the development processing, pH varies, and thus development performance also varies.

Further, in the method in which a predetermined amount of replenishing solution is added at predetermined time intervals or whenever the number of planographic printing plates subjected to a development processing reaches a certain value, the amount of a replenishing solution replenished per unit area of a plate is defined. Accordingly, the amount of a composition in the photosensitive layer dissolved in the developer varies according to the area of an image. Moreover, in the case in which control is performed by using predetermined values, maintaining constant exposure/development conditions has been difficult because these conditions are slightly changed by factors including changes in the amount of CO₂ absorbed by the plate with passage of time depending on the installation environment (such as temperature, humidity, concentration of CO₂, and the like) of the automatic developing machine.

This is not a significant problem for an ordinary planographic printing plate subjected to UV exposure because of its wide latitude. However, as described above, since the positive planographic printing plate for an infrared laser has a narrow latitude, it easily causes a problem of the quality of planographic printing plates. For example, in the case of the ordinary planographic printing plate subjected to UV exposure, when deterioration in development performance reaches 40%, countermeasures can be taken such as increasing the temperature of a developer by 4 to 5°C, increasing electric conductivity by 15 to 30%, or decreasing the speed at which the plate is conveyed in a developing by 40 to 50% so that the development time is increased. However, if these criteria are applied to the positive planographic printing plate for an infrared laser without any change, a problem arises in that slight changes in temperature, electric conductivity or development time greatly affect the development performance, and excessive development or inadequate development is easily caused by these changes.

Under these circumstances, there has been a demand for a method which is applied to the positive planographic printing plate material for an infrared laser having a narrow latitude so that deterioration in the densities of image portions, deterioration in plate wear resistance, or inadequate printing is effectively prevented by simple process control.

### SUMMARY OF THE INVENTION

An object of the present invention is to provide a quality control method in which method plate-making conditions for a positive image forming material for an infrared laser and for direct plate production are determined by using a simple process, and by feeding back the results of determination to a developing process, the planographic printing plate is maintained constant in quality, and uniform images are continuously formed.

As a result of their thorough investigation, the present inventors achieved the present invention after learning that quality control of a planographic printing plate can be easily performed by measuring activity of a standard alkaline developer, measuring activity of an alkaline developer to be evaluated in the same manner, comparing the activities of the two alkaline developers, and feeding back the results of the comparison to the electric conductivity of a developer used in a developing process.

Namely, a first aspect of the present invention is a quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of: (A) preparing a standard alkaline developer and determining the activity of the standard alkaline developer by using a predetermined index; (B) measuring the activity of an alkaline developer to be evaluated by using the same index as that used to determine the activity of the standard alkaline developer; and (C) comparing the activity of the alkaline developer to be evaluated with that of the standard alkaline developer, and, as a result, when the difference between the activities of the two developers exceeds a predetermined value, adjusting the electric conductivity of the alkaline developer to be evaluated in accordance with the difference.

In accordance with the quality control method of the present invention, unlike the conventional method in which electric conductivity which is an index for activity is kept constant, activity is detected by using predetermined indices such as clear sensitivity, solid sensitivity, and the like, and the results of detection is fed back to electric conductivity. As a result, more minute control of development conditions can be carried out, and therefore, the method of the present invention can be preferably applied to quality control of planographic printing plates having a narrow latitude.

Further, in order to increase the accuracy of the quality control method of the present invention, two conditions for controlling the activity of the developer can also be controlled simultaneously.

Namely, a second aspect of the present invention is a quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of: (A) preparing a standard alkaline developer and determining the activity of the standard alkaline developer by using a predetermined index; (B) measuring the activity of an alkaline developer to be evaluated by using the same index as that used to determine the activity of the standard alkaline developer; and (C) comparing the activity of the alkaline developer to be evaluated with that of the standard alkaline developer, and, as a result, when the difference between the activities of the two developers exceeds a predetermined value, adjusting the value of (e-e⁰)²×(t-t⁰)², wherein e is the electric conductivity of the alkaline developer to be evaluated, e⁰ is the electric conductivity of the standard alkaline developer, t is the temperature of the alkaline developer to be evaluated, and t⁰ is the temperature of the standard alkaline developer, in accordance with the difference so that the value falls within a range having a radius of 1.40.

Moreover, a third aspect of the present invention is a quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of: (A) preparing a standard alkaline developer and determining the activity of the standard alkaline developer by using a predetermined index; (B) measuring the activity of an alkaline developer to be evaluated by using the same index as that used to determine the activity of the standard alkaline developer; and (C) comparing the activity of the alkaline developer to be evaluated with that of the standard alkaline developer, and, as a result, when the difference between the activities of the two developers exceeds a predetermined value, adjusting the value of (e-e⁰)²×(s-s⁰)², wherein e is the electric conductivity of the alkaline developer to be evaluated, e⁰ is the electric conductivity of the standard alkaline developer, s is development processing time, and s⁰ is the initial processing time for the standard alkaline developer, in accordance with the difference so that the value falls within a range having a radius of 2.00.

In the third aspect, the standard alkaline developer is an unused alkaline developer at the beginning of a development processing, and the alkaline developer to be evaluated is an alkaline developer which has been continuously used in a predetermined development processing. In this way, the quality control method can be periodically applied to continuous processings carried out in an automatic developing machine or the like, and development conditions can be easily maintained within a predetermined range all the time.

Further, indices for determining the activity of the alkaline developer may be either physical properties of the developer or physical properties of the planographic printing plate obtained. In the case where physical properties of the planographic printing plate obtained are indices for determining the activity of the alkaline developer, it is preferable in terms of evaluation accuracy that a planographic printing plate for evaluation, which has been subjected to exposure under a plurality of conditions while the energy on the surface of the plate is changed in steps, is used as a standard sample, and that physical properties of the planographic printing plate are measured with the state of an image portion or non-image portion under predetermined exposure conditions being used as an index.

### DESCRIPTION OF THE PREFERRED EMBODIMENTS

Hereinafter, the present invention will be described in detail.

In the quality control method for a planographic printing plate according to the present invention, first, (A) a standard alkaline developer is prepared, and then the activity of the standard alkaline developer prepared is determined by using predetermined indices.

Subsequently, (B) the activity of an alkaline developer to be evaluated is measured by using the same indices that have been used to determine the activity of the standard alkaline developer. In general, the developer to be evaluated is a developer used in an automatic developing machine in which a developing process is continuously carried out, and the developer has been used for continuous development processings for a certain period of time. The developer to be evaluated is used to accurately detect deterioration with the passage of time in, and changes in the activity of, the developer which has been used for continuous processings, such that the quality of a planographic printing plate obtained is maintained constant.

Namely, (C) the activity of the standard alkaline developer is compared with the activity of the alkaline developer to be evaluated. When the difference between the activities of the two alkaline developers exceeds a predetermined value, electric conductivity used in the developing process is adjusted.

The method of the present invention is a method in which deviance from a standard state is detected by comparing a developer to be evaluated with the standard alkaline developer serving as a reference, and the obtained results are fed back to a manufacturing process for planographic printing plates.

Specifically, examples of the method include a method in which physical properties of a developer itself such as (1) electric conductivity, (2) electric conductivity and temperature, and (3) electric conductivity and pH are used as the indices for activity.

Further, examples of the method include a method in which physical properties of the positive planographic printing plate for an infrared laser such as (4) densities of image portions (unexposed portions), (5) densities of non-image portions (exposed portions), (6) width of a thin line, (7) density of a 50% dot, (8) highlight reproduction, (9) banding (displacement of connecting portions of a plate setter), (10) clear sensitivity/solid sensitivity, and (11) thin line sensitivity are used as the indices for activity.

In addition to the physical properties of the positive planographic printing plate of the present invention which can be written with an infrared laser, physical properties of a general-purpose planographic printing plate for UV exposure can also be used as the indices for activity evaluation. Namely, the results of evaluation such as (12) sensitivity of a UV exposure type presensitized plate, (13) density of a 50% dot of a UV exposure type presensitized plate, and (14) thin line reproduction of a UV exposure type presensitized plate can also be used as the indices.

Measurement of the indices of the standard alkaline developer serving as a reference may be carried out only once at the beginning, and measured values may be used as the standard values. Conversely, measurement may be carried out periodically at predetermined time intervals such as once every day.

On the other hand, measurement of the indices of the developer to be evaluated is carried out, for example, to check the fatigue condition of the developer after certain time has elapsed. The measurement needs to be carried out at the time evaluation is necessary under the same conditions as those for the measurement of standard values used to determine activity.

Comparison of activities is carried out by using the aforementioned indices. Physical properties of a developer such as electric conductivity and pH can be measured in a conventional manner. Further, when a positive planographic printing plate for an infrared laser or a presensitized plate for UV exposure which has been subjected to exposure and development is to be evaluated, for example, the densities of image portions, non-image portions, 50% dots, and the like can be compared by visual observation or by means such as a densitometer.

Highlight reproduction is determined by exposing/developing planographic printing plates using test patterns which output dots of 0.5%, 1%, 2%, 3%, 4%, and 5%, observing outputted dots with a magnifier and checking which dot can be identified.

Thin line reproduction is determined in the following manner. When a planographic printing plate for recording by an infrared laser is used, a line which has been exposed with a light beam is developed, and the thickness of the line is observed with a magnifier. When a presensitized plate for UV exposure is used, after exposure/development of the plate, the plate is observed with a magnifier so that the minimum thickness (µm) of lines reproduced in accordance with an original is checked.

Banding is evaluated by visually observing the presence of uneven streaks which are formed so as to extend from halftone over non-image portions and correspond to the pitch of multiple beams when the activity of a developer decreases.

Thin line sensitivity refers to an amount of exposure obtained when exposure/development is carried out while the plate surface energy during exposure is changed in steps of 3 to 50%, at which exposure amount a thin line of a predetermined thickness can be observed with a magnifier.

Moreover, in the present invention, clear sensitivity refers to, in a planographic printing original plate which has been exposed/developed while the plate surface energy during exposure is changed stepwise by 3 to 50%, plate surface energy obtained at the minimum exposure amount at which exposed portions are completely dissolved. Solid sensitivity refers to, in the above-described planographic printing original plate, plate surface energy obtained at the maximum exposure amount at which the density of exposed portions is the same as the density of unexposed portions.

In this way, by comparing the activity of a developer to be evaluated with that of the standard developer, whether or not development conditions should be changed or adjusted can be easily determined. Accordingly, by feeding back the results of comparison of the activities to the exposure process, quality control of planographic printing plates can be performed in a reasonable manner. Namely, when there is a decrease in the activity of an object developer which has been tested, measures for making exposure conditions more rigorous may be taken. When there is an increase in the activity, on the other hand, measures for making exposure conditions softer may be taken.

When the results of comparative evaluation are fed back to the exposure process, the limit may be determined by desired uniformity of the planographic printing plate. For example, when electric conductivity is measured and fed back, the measure is ± 4ms/cm, preferably ± 2ms/cm, and more preferably ± 1ms/cm with respect to a standard value. Further, in a case in which the density of image portions is used as an index, when there is a change in the density of image portions by 0.05, preferably 0.03, and more preferably 0.02 on a densitometer, feedback is perfomed when there is a change in the density of non-image portions by 0.03, preferably 0.02, and more preferably 0.01. Furthermore, when sensitivity is used as an index, feedback is carried out when sensitivity exceeds a range of ± 20%. In the case of the presensitized plate for UV exposure, this corresponds to G/S ± 0.5 levels.

Among various methods, a method in which a standard planographic printing plate sample which has been subjected to predetermined stepwise exposure is used and densities at predetermined portions are compared with each other is preferable in that accuracy of activity evaluation is improved and that even a beginner can easily see changes in activity.

In the planographic printing plate for evaluation (hereinafter appropriately referred to as an "original plate for evaluation") which is subjected to such stepwise exposure, for example, by changing the output of a laser beam, exposed portions are formed stepwise on an image forming material which has a support and a photosensitive layer thereon containing an alkaline water-soluble resin and a compound which absorbs light and generates heat. At this time, the difference in plate surface energy between adjacent exposed portions is preferably 3 to 50%. When more precise control is carried out, the difference is more preferably 3 to 20%, and most preferably 5 to 10%.

Such original plates for evaluation may be independently produced and each disposed with predetermined intervals between planographic printing plates being produced in an apparatus in which ordinary development and plate-making processings are carried out, such that plate-making conditions are checked. Quality control can also be performed by forming, with such stepwise exposure, an exposed portion for evaluation at a margin, i.e., a frame portion, of a planographic printing plate being produced, and by checking the plate-making state.

The original plate for evaluation produced as described above is first subjected to development by using a standard developer having a standard composition to obtain a planographic printing plate treated with a standard developer. Further, a planographic printing plate for evaluation which has been subjected to exposure under the same conditions as those described above is subjected to development in the same manner as that for the planographic printing plate treated with a standard developer except that the planographic printing plate for evaluation is developed by using a developer to be evaluated. In this way, a planographic printing plate treated with an object developer is obtained. In a process of comparing activities from these results, evaluation may be made by comparing the development states of image portions or non-image portions under the same exposure conditions. In terms of ensuring no variation in evaluation, evaluation is preferably made by determining plate surface energy at the minimum exposure amount at which exposed portions are completely dissolved (in the present invention, this is hereinafter referred to as "clear sensitivity") or plate surface energy at the maximum exposure amount at which the density of exposed portions is the same as the density of unexposed portions (in the present invention, this is hereinafter referred to as "solid sensitivity") and comparing clear sensitivity and/or solid sensitivity of the standard developer with clear sensitivity and/or solid sensitivity of the object developer.

As described above, by comparing the activity of a developer to be evaluated with that of a standard developer, whether or not the exposure conditions should be changed or adjusted can be easily determined. Accordingly, by feeding back the results of comparison of the activities to the developing process, quality control of planographic printing plates can be carried out in a reasonable manner. Namely, when there is a decrease in the activity of the object developer tested, electric conductivity of the alkaline developer in the developing process may be increased. When there is an increase in the activity, on the other hand, electric conductivity of the alkaline developer may be decreased.

When the results of evaluation are fed back to the developing process, the limit may be determined by desired uniformity of the planographic printing plate. In general, however, when clear sensitivity and solid sensitivity respectively deviate from those of the standard sample by 20%, i.e., when (data of an object planographic printing plate which has been subjected to a development processing)/(data of the standard planographic printing plate which has been subjected to a development processing) = outside the range of 0.8 to 1.2 is the time to set up a measure for feeding back the results of evaluation to the developing process.

In order to adjust electric conductivity of an alkaline developer in the developing process, an electric conductivity measuring means and a replenishing device which can supply a predetermined liquid may be disposed at a development tank.

In the present invention, examples of means for measuring electric conductivity of the developer include well known measuring devices such as electric conductivity measuring devices using AC bridge including, for example, electric conductivity measuring devices commercially available from DKK-Toa Corporation and Horiba, Ltd..

As a countermeasure for deviation of the activity from the specified range, when the activity is increasing, water or a developer of low concentration such as approximately 1/2 to 1/5 of that of the solution being used is added, or CO₂ gas is blown in. As a general measure for adjustment, when either clear sensitivity or solid sensitivity is increased relative to clear sensitivity or solid sensitivity of the standard sample by 40% according to the above-described evaluation method, electric conductivity is decreased by about 4 to 10%.

Further, as a countermeasure for deviation of the activity from the specified range due to a decrease in the activity, a replenishing solution having a concentration approximately twice to five times as high as that of the working solution is added, or the amount of the replenishing solution added is increased. As a general measure for adjustment, when, contrary to the case in which the activity is increased, either clear sensitivity or solid sensitivity is decreased relative to clear sensitivity or solid sensitivity of the standard sample by 40%, electric conductivity is increased by about 4 to 10%.

For example, in the case of a general-purpose positive planographic printing plate for UV exposure, when clear sensitivity and solid sensitivity respectively deviate from those of the standard sample by 40%, it is necessary to change electric conductivity by at least 15% or more. Taking this into consideration, it is clear that highly accurate adjustment of electric conductivity is required for the positive planographic printing plate for an infrared laser.

Further, when only electric conductivity is adjusted, depending on the condition, adjusting the contents of active components of the alkaline developer may be difficult. In such a case, by controlling two conditions, i.e., not only electric conductivity but also temperature or development processing time, more accurate quality control can be carried out.

Namely, in the process (C), in a case in which the difference in the activities exceeds a predetermined value, when the electric conductivity of the alkaline developer is e, the electric conductivity of the standard alkaline developer is e⁰, the temperature of the alkaline developer is t, and the temperature of the standard developer is t⁰, the activity can be held within a preferable range by controlling the product of the two within a predetermined range. Setting the value of (e - e⁰) × (t - t⁰) to be constant means controlling so that the product of the two is placed within the area of a predetermined quadrilateral with electric conductivity being the ordinate and temperature being the abscissa. Moreover, it is also preferable that control is carried out so that the value of (e - e⁰)² × (t - t⁰)² is placed within a predetermined range, namely, within a circle having a predetermined radius, and preferably a radius of 1.40.

Further, in the process (C), when the electric conductivity of the alkaline developer is e, the electric conductivity of the standard alkaline developer is e⁰, the development processing time is s, and the initial processing time in the standard alkaline developer is s⁰, it is also preferable that, in accordance with the difference in the activities, the product of the two, namely, the value of (e - e⁰)² × (s - s⁰)², is adjusted so as to be within the range having a radius of 2.00.

An image forming material to which the method of the present invention is applied will be described hereinafter.

The image forming material according to the present invention is not particularly limited as long as it includes a support and a photosensitive layer thereon which is made of a positive photosensitive composition for an infrared laser. The photosensitive layer includes (a) an alkaline water-soluble resin and (b) a compound which absorbs light and generates heat. Further, an additive or the like which is normally used as a positive photosensitive composition for an infrared laser may be added to the photosensitive layer.

Examples of (a) the alkaline water-soluble resin used in the present invention include novolak resins, polymers having a hydroxyaryl group at a side chain, and the like.

Novolak resins which can be used as the alkaline water-soluble resin of the present invention are resins formed by condensing phenols and aldehydes under acidic conditions.

Examples of preferable novolak resins include novolak resins obtained from phenol and formaldehyde, novolak resins obtained from m-cresol and formaldehyde, novolak resins obtained from p-cresol and formaldehyde, novolak reins obtained from o-cresol and formaldehyde, novolak resins obtained from octylphenol and formaldehyde, novolak resins obtained from m-/p- mixed cresol and formaldehyde, novolak resins obtained from a mixture of phenol/cresol (any of m-, p-, o-, or m-/p- mixed, m-/o- mixed, o-/p-mixed) and formaldehyde, and the like.

It is preferable that these novolak resins have a weight average molecular weight of 800 to 200000 and a number average molecular weight of 400 to 60000.

Further, preferable examples of the alkaline water-soluble resin of the present invention include polymers having a hydroxyaryl group at a side chain.

In this polymer, a hydroxyaryl group refers to an aryl group having one or more -OH radicals bonded thereto. Examples of the aryl groups include phenyl groups, naphthyl groups, anthracenyl groups, phenanthrenyl groups, and the like. However, in terms of availability and physical properties, phenyl groups or naphthyl groups are preferable. Accordingly, as hydroxyaryl groups, hydroxyphenyl groups, dihydroxyphenyl groups, trihydroxyphenyl groups, tetrahydroxyphenyl groups, hydroxynaphthyl groups, dihydroxynaphthyl groups, and the like are preferable. Further, these hydroxyaryl groups may have substituents such as halogen atoms, hydrocarbon radicals having 20 or less carbons, alkoxy groups having 20 or less carbons, and aryloxy groups having 20 or less carbons. These hydroxyaryl groups are bonded to the principal chain of the polymer as side chains thereof in a pendant manner. However, they may have connecting radicals between the principal chain and the hydroxyaryl groups.

Preferable examples of (b) the compound which absorbs light and generates heat include various well-known pigments, dyes, and the like.

Examples of the pigments include commercially available pigments and pigments disclosed in the Color Index (C.I.) Handbook; "Modern Pigment Handbook" edited by The Japan Pigment Technology Association, published in 1977; "Modern Pigment Application Technology" by CMC Press, published in 1986; and "Printing Ink Technology" by CMC Press, published in 1984.

Examples of pigments include black pigments, yellow pigments, orange pigments, brown pigments, red pigments, purple pigments, blue pigments, green pigments, fluorescent pigments, metal powder pigments, and polymer bond pigments. Specifically, insoluble azo pigments, azo lake pigments, condensation azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, colored lake pigments, azine pigments, nitroso pigments, nitro pigments, natural pigments, fluorescent pigments, inorganic pigments, and carbon black can be used.

These pigments can be used without being subjected to a surface treatment, or can be used after being subjected to a surface treatment. Examples of surface treatment methods include a method of surface coating with a resin or a wax, a method of adhering a surfactant, and a method of bonding a reactive substance (such as a silane coupling agent, an epoxy compound, or polyisocyanate) with the pigment surface. The above-mentioned surface treatment methods are disclosed in "Natures and Applications of Metal Soaps" by Sachi Press; "Printing Ink Technology" by CMC Press, published in 1984; and "Modern Pigment Application Technology" by CMC Press, published in 1986.

A pigment particle size of 0.01 to 10 µm is preferable, 0.05 to 1 µm is more preferable, and 0.1 to 1 µm is particularly preferable.

A pigment particle size smaller than 0.01 µm is not preferable in terms of the stability of the pigment dispersion in a photosensitive layer coating solution. On the other hand, a pigment particle size larger than 10 µm is not preferable in terms of the uniformity of the photosensitive layer.

As methods of dispersing a pigment, known dispersing methods employed in ink production or toner production can be used. Examples of dispersing machines used for the dispersion include ultrasonic dispersing machines, sandmills, attritors, pearl mills, super mills, ball mills, impellers, dispersers, KD mills, colloid mills, dynatrons, triple roll mills, and pressure kneaders. Details thereof are described in "Modern Pigment Application Technology" by CMC Press, published in 1986.

As for the dyes, known dyes such as those commercially available or disclosed in the literature (such as "Dye Handbook" edited by The Organic Synthetic Chemistry Association, published in 1970) can be used. Examples of dyes include azo dyes, metal complex azo dyes, pyrazolone azo dyes, anthraquinone dyes, phthalocyanine dyes, carbonium dyes, quinoneimine dyes, methyne dyes, and cyanine dyes.

Among the above pigments or dyes, pigments or dyes absorbing infrared rays or near infrared rays are particularly preferable as they are suitable for use in lasers emitting infrared rays or near infrared rays.

Carbon black is preferably used as the pigment which absorbs infrared rays or near infrared rays. Further, examples of dyes which absorbs infrared rays or near infrared rays include cyanine dyes disclosed in Japanese Patent Application Laid-Open (JP-A) Nos. 58-125246, 59-84356, 59-202829, 60-78787, and the like; methyne dyes disclosed in JP-A Nos. 58-173696, 58-181690, 58-194595, and the like; naphthoquinone dyes disclosed in JP-A Nos. 58-112793, 58-224793, 59-48187, 59-73996, 60-52940, 60-63744, and the like; squalirium dyes disclosed in JP-A No. 58-112792 and the like; and cyanine dyes disclosed in GB Patent No. 434,875 and the like.

Moreover, near infrared absorbing sensitizers disclosed in U.S. Patent No. 5,156,938 are preferably used as the dyes. Further, substituted arylbenzo(thio)pyrylium salts disclosed in U.S. Patent No. 3,881,924; trimethynethiapyrylium salts disclosed in JP-A No. 57-142645 (U.S. Patent No. 4,327,169); pyrylium-based compounds disclosed in JP-A Nos. 58-181051, 58-220143, 59-41363, 59-84248, 59-84249, 59-146063, and 59-146061; cyanine dyes disclosed in JP-A No. 59-216146; pentamethynethiopyrylium salts disclosed in U.S. Patent No. 4,283,475; and pyrylium compounds disclosed in Japanese Patent Application Publication (JP-B) Nos. 5-13514 and 5-19702 are also used preferably as the dyes. As for commercially available products, Epolight III-178, Epolight III-130, Epolight III-125, Epolight V-176A manufactured by Epolin Inc., and the like are preferably used.

Furthermore, particularly preferable examples of the dyes are near infrared absorbing dyes disclosed in the specification of U.S. Patent No. 4,756,993 as formulae (I) and (II).

These dyes or pigments can be added to the planographic printing plate material preferably in an amount of 0.01 to 50% by weight, more preferably in a amount of 0.1 to 10% by weight, and particularly preferably in an amount of 0.5 to 10% by weight in the case of a dye, and particularly preferably in an amount of 3.1 to 10% by weight in the case of a pigment, based on the total solids of the planographic printing plate material.

An amount of a pigment or a dye of less than 0.01% by weight may cause low sensitivity. On the other hand, an amount of more than 50% by weight may cause lack of uniformity in the photosensitive layer and deterioration in durability of the recording layer.

These dyes or pigments can be added in a layer with other components, or can be added in a layer which is different from the layer containing the other components. In the latter case, it is preferable that the dyes or pigments are added in a layer adjacent to a layer containing substances which are thermally decomposable and substantially lower the solubility of a binding resin when not decomposed. Further, the dyes or pigments are preferably contained in a layer together with the binding resin, but may be contained in a layer different from a layer containing the binding resin.

Other components may be contained in the photosensitive layer if desired. Examples of the other components include various additives such as onium salts, o-quinondiazide compounds, aromatic sulfone compounds, and esters of aromatic sulfonic acids. These components are substances which are thermally decomposable and substantially lower the solubility of the alkaline water-soluble polymer compound when not decomposed. Addition of such additives improves the ability to prevent the dissolution of image portions in the developer.

Examples of the onium salts include diazonium salt, ammonium salt, phosphonium salt, iodonium salt, sulphonium salt, selenonium salt, and arsonium salt.

Among these onium salts, diazonium salt is particularly preferable. In particular, diazonium salt disclosed in JP-A No. 5-158230 is preferable.

As the o-quinonediazide compounds, compounds having various structures may be preferably used as long as they have one or more o-quinondiazide radicals and their solubility in alkali is increased by thermal decomposition.

O-quinonediazide has two effects, namely, an effect of taking away the dissolution suppressing ability of a binding agent by thermal decomposition and an effect of changing itself into an alkaline soluble substance. Therefore, o-quinonediazide can act as a dissolution accelerator for the binding agent.

The amount of o-quinondiazide to be added is preferably 1 to 50% by weight, more preferably 5 to 30% by weight, and particularly preferably 10 to 30% by weight, based on the total solids of the printing plate material.

Examples of counter ions of the onium salts described above include a tetrafluoroboric acid, a hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, a dodecylbenzenesulfonic acid, 1-naphtol-5-sulfonic acid, 2-methoxy-4-hydroxy-5-benzoylbenzenesulfonic acid, and p-toluenesulfonic acid. Among these counter ions, alkylaromatic sulfonic acids such as hexafluorophosphoric acid, triisopropylnaphthalenesulfonic acid, and 2,5-dimethylbenzenesulfonic acid are particularly preferred.

The amount of additives other than the o-quinonediazide compound to be added is preferably 1 to 50% by weight, more preferably 5 to 30% by weight, and particularly preferably 10 to 30% by weight. The additives and the binding agent are preferably contained in a single layer.

Further, cyclic acid anhydrides such as phthalic anhydride, phenols such as bisphenol A and p-nitrophenol, and organic acids such as p-toluenesulfonic acid and dodecylbenzenesulfonic acid can also be added to further improve sensitivity.

The amount of the cyclic acid anhydrides, phenols or organic acids is preferably 0.05 to 20% by weight, more preferably 0.1 to 15% by weight, and particularly preferably 0.1 to 10% by weight of the printing plate material.

In order to improve application properties, the photosensitive layer may contain a surfactant such as a fluorine-based surfactant disclosed in JP-A No. 62-170950. The amount of the surfactant to be added is preferably 0.01 to 1% by weight, and more preferably 0.05 to 0.5% by weight of the image recording material.

The image recording material of the present invention is formed by dissolving the above-described components in a solvent and applying the resultant solution onto a support which will be described hereinafter.

### Support

Examples of the support include dimensionally stable platelike materials such as paper, paper laminated with plastic (such as polyethylene, polypropylene, and polystyrene), metal plates (such as aluminum, zinc, and copper), plastic films (such as cellulose diacetate, cellulose triacetate, cellulose propionate, cellulose butyrate, cellulose acetate/butyrate, cellulose nitrate, polyethylene terephthalate, polyethylene, polystyrene, polypropylene, polycarbonate, and polyvinyl acetal), and paper or plastic films laminated or deposited with the above-mentioned metals.

A polyester film or an aluminum plate is preferable as a support. In particular, an aluminum plate is preferable since it has good dimensional stability and can be provided at a relatively low cost. Examples of preferable aluminum plates include pure aluminum plates and alloy plates containing aluminum as the main component and trace quantities of different elements. Furthermore, plastic films to which aluminum is laminated or deposited can also be used. Examples of different elements included in an aluminum alloy include silicon, iron, manganese, copper, magnesium, chrome, zinc, bismuth, nickel, and titanium. The total amount of the different elements in the alloy is preferably 10% by weight or less. Pure aluminum is preferable as an aluminum plate. However, since production of completely pure aluminum is difficult in terms of refining technology, an aluminum alloy containing trace quantities of different elements can be used. The composition of the aluminum plate is not specifically defined, and a known aluminum plate can be suitably used. The thickness of the aluminum plate is preferably about 0.1 to 0.6 mm, more preferably 0.15 to 0.4 mm, and particularly preferably 0.2 to 0.3 mm.

Prior to roughening the surface of the aluminum plate, a degreasing treatment with a surfactant, an organic solvent, an aqueous alkaline solution or the like is conducted for removing the rolling oil on the surface as needed.

The surface roughening treatment of the aluminum plate can be implemented by using various methods, such as a mechanical roughening method, an electrochemical roughening method in which the plate surface is dissolved, and a chemical roughening method in which the plate surface is dissolved selectively. As a mechanical method, known methods such as a ball abrasion method, a brush abrasion method, a blast abrasion method, and a buff abrasion method can be used. As an electrochemical roughening method, a method in which an alternating current or direct current is applied to a plate in an electrolyte containing a hydrochloric acid or nitric acid is used.

An aluminum plate to which a surface roughening treatment has been applied may be subjected to an alkaline etching treatment or a neutralizing treatment, if necessary, followed by an anodic oxidation treatment so as to improve the water retention property and the ablasion resistance property of the surface, if desired. The amount of an anodically oxidized film is preferably 1.0 g/m² or more. An amount of an anodically oxidized film less than 1.0 g/m² may result in insufficient plate wear resistance. When the anodically oxidized film having less than 1.0 g/m² is used for a planographic printing plate, scratches may be easily formed in non-image portions of the planographic printing plate, and there is a tendency toward so-called "coloring" which occurs by ink adhering to the scratches.

After the anodic oxidation treatment, a hydrophilic treatment is applied to the aluminum surface, if necessary.

The concentration of the above-mentioned positive photosensitive composition for an infrared laser (total solids including additives) is preferably 1 to 50% by weight in the solvent. The amount (solids) applied onto the support obtained after application and drying is determined according to the purpose for which the image forming material is to be used. However, when the image forming material is used for production of a photosensitive printing plate, the applied amount (solids) of the above-mentioned composition is preferably 0.5 to 5.0 g/m².

The application method is not particularly limited. Various known methods can be used such as bar coater application, rotation application, spray application, curtain application, dip application, air knife application, blade application, and roll application.

As the application amount decreases, the apparent sensitivity increases, but the film characteristics of the photosensitive layer decrease.

The above-described image forming material is subjected to image exposure and a development processing such that a planographic printing plate is manufactured.

As the light source for an active light beam used in the image exposure, a light source emitting light of wavelengths in the near infrared region to the infrared region is preferable. Particularly preferable are a solid state laser and a semiconductor laser.

Conventionally known aqueous alkaline solutions can be used as the developer and replenishing solution used in the development processing. Examples include inorganic alkali salts such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide, and lithium hydroxide. Further, organic alkaline agents such as the following can also be used: monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and the like. These alkaline solutions may be used alone, or a combination of two or more may be used.

Particularly preferable among these alkaline water-soluble solutions is an aqueous solution of silicate, such as sodium silicate or potassium silicate. This is because the developing property can be adjusted by the ratio and concentration of silicon dioxide SiO₂ which is a component of silicate and an alkali metal oxide M₂O. Preferable examples of alkali metal silicate include those disclosed in JP-A-No. 54-62004 and JP-B No. 57-7427.

Furthermore, when development is carried out by using an automatic developing machine, by adding to the developer an aqueous solution (replenishing solution) whose alkalinity is higher than that of the developer, a large amount of presensitized plates can be developed without changing the developer in the developing tank for a long time.

Various types of surfactants and organic solvents can be added to the developer and the replenishing solution as needed for promoting or suppressing the developing property, and improving the dispersion of developing scum (debris) and the affinity of the printing plate image portions to ink. Examples of preferable surfactants include anionic surfactants, cationic surfactants, nonionic surfactants, and ampholitic surfactants. Further, a reducing agent such as hydroquinone, resorcine, a sodium or potassium salt of an inorganic acid such as sulfurous acid or sulfurous hydroacid; an organic carboxylic acid; an antifoamer; and a hard-water softener may also be added to the developer and the replenishing solution as needed.

Image forming materials developed by using the above-mentioned developers and replenishing solutions are subjected to a post-treatment with a rinsing solution containing water, a surfactant, or the like, and a desensitizing solution containing gum arabic or a starch derivative. In a case in which the image forming material is used for a printing plate, these treatments can be used in combination as a post-treatment.

Recently, an automatic developing machine has been widely used in plate making and printing industries in order to streamline and standardize the plate-making operation. In general, this automatic developing machine comprises a developing section and a post-treatment section, and each section comprises a device for conveying a printing plate, processing solution tanks, and spraying devices. The development processing is carried out by spraying a processing solution, which is pumped up by a pump, from a spray nozzle onto the printing plate after exposure while the printing plate is horizontally conveyed. In addition, a processing method has also been known recently in which a printing plate which has been exposed is subjected to processing by being immersed in a processing solution tank filled with a processing solution while the printing plate is conveyed in the solution by guide rollers. In such automatic processing, a replenishing solution can be replenished for each treatment in accordance with the amount of printing plates to be developed, the work time, and the like.

Further, a so-called disposable processing method, in which a substantially unused processing solution is utilized for treatment, can be applied as well.

By applying the quality control method of the present invention to the developing process described above, a planographic printing plate having stable quality can be continuously obtained.

A description will be given of a case in which the above-described image forming material is used as a photosensitive planographic printing plate.

First, in a case in which a planographic printing plate obtained by image exposure, development, washing with water, and /or rinsing and/or gum coating has unnecessary image portions (for example, traces of film edges of the original film or the like), such unnecessary image portions are removed.

It is preferred that removal is carried out by applying a removing solution such as that described in JP-B No. 2-13293 onto the unnecessary image portions, allowing the printing plate to stand for a given period of time, and then washing the printing plate with water. Also, the method described in JP-A No. 59-174842 may be used in which unnecessary image portions are irradiated with an active light beam guided through an optical fiber and the printing plate is developed thereafter.

If desired, a desensitizing gum may be applied to a planographic printing plate which has been subjected to the above-described treatments, and thereafter, the printing plate may be used in a printing process. The plate may be subjected to a burning treatment for the purpose of improving plate wear resistance.

The planographic printing plate obtained by such treatment is loaded in an offset printing machine and is used for printing of a large number of sheets.

### EXAMPLES

The present invention will now be described in detail by way of Examples. However, the present invention is not limited to these Examples.

### Example 1

### [Synthesis of specific copolymer 1]

Into a 500 ml three-neck flask equipped with a stirrer, a condenser and a dropping funnel, 31.0 g (0.36 mole) of methacrylic acid, 39.1 g ( 0.36 mole) of ethyl chloroformate, and 200 ml of acetonitrile were introduced, and the resulting mixture was stirred while being cooled in an ice-water bath. Through the dropping funnel, 36.4 g (0.36 mole) of triethylamine was added dropwise to the mixture over about one hour. Thereafter, the ice-water bath was removed, and the mixture was stirred at room temperature for 30 minutes.

To this reaction mixture, 51.7 g (0.30 mole) of p-aminobenzenesulfonamide was added, and then the mixture was stirred for one hour while being heated to 70°C in an oil bath. After the reaction was finished, this mixture was added to one liter of water while the water was stirred, and then the resulting mixture was stirred for 30 minutes. The mixture was filtered to remove the precipitates. 500 ml of water was added to the precipitates to obtain a slurry, and then this slurry was filtered. The obtained solid was dried to yield a white solid of N-(p-aminosulfonylphenyl)methacrylamide (yield: 46.9 g).

Subsequently, into a 20 ml three-neck flask equipped with a stirrer, a condenser and a dropping funnel, 4.61 g (0.01 mole) of N-(p-aminosulfonylphenyl)methacrylamide, 2.94 g (0.0258 mole) of ethyl methacrylate, 0.80 g (0.015 mole) of acrylonitryl and 20 g of N,N-dimethylacetamide were introduced, and the resulting mixture was stirred while being heated to 65°C in a hot water bath. To the mixture, 0.15 g of "V-65" (produced by Wako Pure Chemical Industries, Ltd.) was added, and then the mixture was stirred under a nitrogen gas flow for two hours while a temperature of 65°C was maintained. To this reaction mixture, a mixture of 4.61 g of N-(p-aminosulfonylphenyl)methacrylamide, 2.94 g of ethyl methacrylate, 0.80 g of acrylonitryl, 0.15 g of N,N-dimethylacetamide, and 0.15 g of "V-65" was added dropwise through the dropping funnel over two hours. After this dropwise addition was finished, the resultant mixture was stirred at 65°C for two hours. After the reaction was finished, 40 g of methanol was added to the mixture, and the mixture was cooled. The mixture thus obtained was introduced into two liters of water while the water was stirred, and then the resultant mixture was stirred for 30 minutes. Thereafter, the precipitates were removed by filtration, and then dried to obtain 15 g of a white solid. The weight average molecular weight (polystyrene reference) of the resultant specific copolymer 1 was measured by gel permeation chromatography and found to be 53000.

### [Production of substrate]

An aluminum plate (material quality: 1050) having a thickness of 0.3 mm was washed with trichloroethylene to remove grease, and then the surface was grained with a nylon brush and a suspension of a 400 mesh pumice stone in water, and then was washed well with water. The plate was dipped into a 25% sodium hydroxide aqueous solution at 45°C for 9 seconds to be etched. After being washed with water, the plate was dipped into 20% nitric acid for 20 seconds and then washed with water. The etched amount of the grained surface was about 3 g/m². By direct current-anodic oxidation at a current density of 15A/dm² using 7% sulfuric acid as an electrolyte, a direct current anodically oxidized film of 3 g/m² was formed on the plate. Thereafter, the plate was washed with water and dried. Subsequently, the plate was treated with an aqueous solution containing 2.5% by weight of sodium silicate at 30°C for 10 seconds. An undercoat solution having the following composition was applied to the plate, and the applied film was dried at 80°C for 15 seconds to obtain a substrate. The amount of the applied film after drying was 15 mg/m².

| [Undercoat solution 1] | |
|---|---|
| Copolymer of the following formula (molecular weight: 28000) | 0.3 g |
| Methanol | 100 g |
| Water | 1 g |

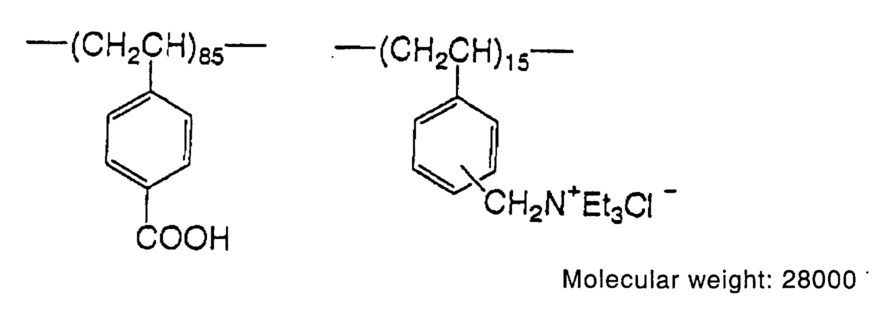

A photosensitive solution 1 having the following composition was prepared. The photosensitive solution 1 was applied to the substrate to obtain a planographic printing plate 1. The amount of the photosensitive solution 1 applied to the substrate was 1.3 g/m².

| [Photosensitive solution 1] | |
|---|---|
| Fluorine-containing polymer P-6 | 0.03 g |
| (of the following formula) | |
| Specific copolymer 1 | 0.75 g |
| m,p-cresol novolak (m/p ratio = 6/4, weight average molecular weight: 3500, non-reacted cresol was contained in an amount of 0.5% by weight) | 0.25 g |
| p-toluenesulfonic acid | 0.003 g |
| Tetrahydrophthalic anhydride | 0.03 g |
| Cyanine dye A (having the following structure) | 0.017 g |
| Dye prepared by replacing the counter anion of Victoria Pure Blue BOH with an anion of 1-naphthalenesulfonic acid | 0.015 g |
| 3-methoxy-4-diazodiphenylaminehexafluorophosphate | 0.02 g |
| Fluorine-containing surfactant (Megafac F-177, manufactured by Dainippon Ink & Chemicals, Inc.) | 0.05 g |
| γ-butyrolactone | 10 g |
| Methylethylketone | 10 g |
| 1-methoxy-2-propanol | 8 g |

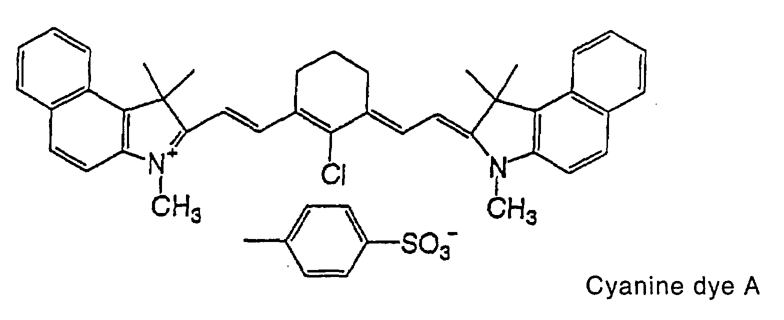

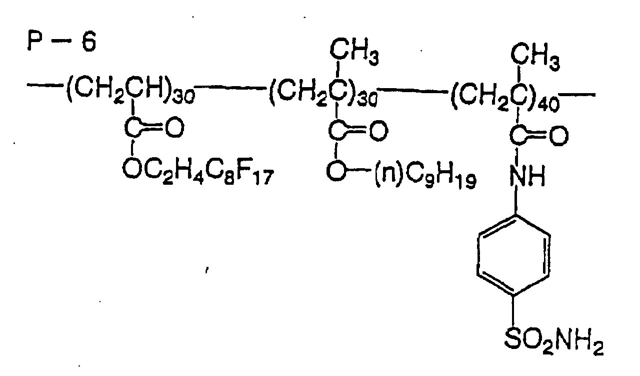

Subsequently, in a first development processing tank of a commercially available automatic developing machine LP-900H (manufactured by Fuji Photo Film Co., Ltd.) having immersion-type developing tanks, 22.5 liters of an alkaline developer A having the following composition was used and maintained at 30°C. Eight liters of tap water was used in a second bath of the LP-900H. Used in a third bath was eight liters of a finishing gum solution with a dilution ratio of FP-2W (produced by Fuji Photo Film Co., Ltd.) to water being 1:1.

| [Composition of alkaline developer A] | |
|---|---|
| D sorbitol | 2.5% by weight |
| Sodium hydroxide | 0.85% by weight |
| Pentasodium salt of diethylenetriaminepenta(methylenephosphonic acid) | 0.05% by weight |
| Water | 96.6% by weight |

Planographic printing plates (650 mm × 550 mm and thickness of 0.3 mm), which have been subjected to an exposure processing, were subjected to a development processing (100 plates a day) while a developer replenishing solution B having the following composition was replenished. Impedance of development replenishing control in the automatic developing machine LP-900H was set to 40.5 ms/cm.

| [Composition of developer replenishing solution B] | |
|---|---|
| D sorbitol | 5.6% by weight |
| Sodium hydroxide | 2.5% by weight |
| Pentasodium salt of diethylenetriaminepenta(methylenephosphonic acid) | 0.2% by weight |
| Water | 91.7% by weight |

By using Luxcel Platesetter 9000CTP (a plate setter manufactured by Fuji Photo Film Co., Ltd.; output: 216 mW, revolution speed:1000 rpm, resolution: 2438 dpi, and image area: about 20%), planographic printing plates 1 (650 mm × 550 mm and thickness of 0.3 mm) were subjected to exposure and development processings (100 plates a day). The development processing was carried out for three months.

Every day, exposure and development were carried out by using the original pattern of the Luxcell Platesetter 9000CTP and changing the exposure amount from 27 mW (13.5 mJ/cm²) to 270 mW (135 mJ/cm²) at intervals of 13.5 mW (7.5 mJ/cm²). Namely, exposure was carried out in steps so that the plate surface energy was 10%, 15%, ..., 90%, 95%, and 100% of the maximum value. Therefore, the difference in the plate surface energy between adjacent exposed portions was 5%.

Clear sensitivity and solid sensitivity were respectively determined by using this original pattern.

On the first day of the processings, solid sensitivity was 40.5 mJ/cm², and clear sensitivity was 81 mJ/cm².

Therefore, when solid sensitivity was outside the range of 33.8 to 47.2 mJ/cm² and clear sensitivity was outside the range of 67.5 to 101.3 mJ/cm², electric conductivity of the alkaline developer was changed so that the solid sensitivity and clear sensitivity fell in the respective ranges.

In accordance with the developer control method of the present invention, a development processing was carried out in a stable manner for 90 days. On the 20th day of the processing, clear sensitivity decreased to 103 mJ/cm², which was lower than the initially set exposure amount. Therefore, based on the control method of the present invention, feedback was performed in such a way that the initially set electric conductivity (45.0 ms/cm) of the alkaline developer was increased by 4.0% to 46.8 ms/cm so that the clear sensitivity fell within the above-mentioned range. Specifically, of 22.5 liters of an alkaline developer having an electric conductivity of 45.0 ms/cm, 3.38 liters were taken out and replaced with 3.38 liters of an alkaline developer replenishing solution having an electric conductivity of 57.0 ms/cm such that the electric conductivity of the mixed developer became 46.8 ms/cm. On the 35th day, clear sensitivity became 64 mJ/cm². Since the electric conductivity of the alkaline developer was 46.8 ms/cm, 0.87 liters of the developer was taken out, and 0.87 liters of water was added to the developer such that the electric conductivity decreased by 4.0% to 45.0 ms/cm and the clear sensitivity fell within the above range of setting values. When printing was performed by using the obtained planographic printing plates, printing matter having good quality was obtained in which image portions had a satisfactory density and non-image portions had no coloring or stains.

If the control method of the present invention had not been used, it would have been possible for the automatic developing machine to operate under conditions in which planographic printing plates in a desirable state could be obtained for only 20 days. Therefore, it can be seen that the control method of the present invention is effective.

### Example 2

### [Production of planographic printing plate]

An aluminum plate (material quality: 1050) having a thickness of 0.3 mm was washed with trichloroethylene to remove grease, and then the surface was grained with a nylon brush and a suspension of a 400 mesh pumice stone in water, and was washed well with water. The plate was dipped into a 25% sodium hydroxide aqueous solution at 45°C for 9 seconds to be etched. After being washed with water, the plate was dipped into 20% nitric acid for 20 seconds and then washed with water. The etched amount of the grained surface was about 3 g/m². By direct current-anodic oxidation at a current density of 15A/dm² using 7% sulfuric acid as an electrolyte, a direct current anodically oxidized film of 3 g/m² was formed on the plate. Thereafter, the plate was washed with water and dried.

Subsequently, the plate was treated with an aqueous solution containing 2.5% by weight of sodium silicate at 30°C for 10 seconds. An undercoat solution having the following composition was applied to the plate, and the applied film was dried at 80°C for 15 seconds to obtain a substrate. The amount of the applied film after drying was 15 mg/m².

| [Undercoat solution 1] | |
|---|---|
| The above-described copolymer (molecular weight: 28000) | 0.3 g |
| Methanol | 100 g |
| Water | 1 g |

An application solution having the following composition for forming a photosensitive layer was applied to the substrate to obtain a planographic printing plate 2. The amount of the application solution applied to the substrate was 1.8 g/m².

| [Photosensitive solution 2] | |
|---|---|
| m,p-cresol novolak | 1.0 g |
| (m/p ratio = 6/4, weight average molecular weight: 8000, non-reacted cresol was contained in an amount of 0.5% by weight) | |
| Pyrylium salt dye B (having the following | 0.1 g |
| structure) | |
| Phthalic anhydride | 0.05 g |
| p-toluenesulfonic acid | 0.002 g |
| Dye prepared by replacing the counter anion of Ethyl Violet with 6-hydroxy-β naphthalenesulfonic acid | 0.02 g |
| Fluorine-containing surfactant | 0.05 g |
| (Megafac F-177, manufactured by Dainippon Ink & Chemicals, Inc.) | |
| Methylethylketone | 8 g |
| 1-methoxy-2-propanol | 4 g |

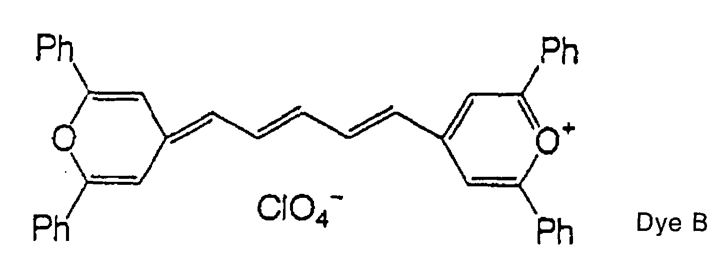

Subsequently, into a first development processing tank of the commercially available automatic developing machine LP-900H having immersion-type developing tanks, 22.5 liters of an alkaline developer C (pH: about 13) having the following composition was introduced and maintained at 30°C. Eight liters of tap water was introduced into the second bath of the LP-900H. Introduced into the third bath was eight liters of a finishing gum solution with a dilution ratio of the FP-2W to water being 1:1.

| [Composition of alkaline developer C] | |
|---|---|
| SiO₂·K₂O (K₂O/ SiO₂ = 1.1 in molar ratio) | 4.0% by weight |
| Citric acid | 0.5% by weight |
| Polyethylene glycol (weight average molecular weight: 1000) | 0.5% by weight |
| Water | 95.0% by weight |

On planographic printing plates 2 (650 mm × 550 mm and thickness of 0.24 mm) which have been subjected to an exposure processing, a development processing was carried out in such a way that a developer replenishing solution D having the following composition was replenished in an amount of 35 cc for every development processing carried out on a planographic printing plate in the LP-900H.

| [Composition of developer replenishing solution D] | |
|---|---|
| SiO₂·K₂O (K₂O/SiO₂ = 1.1 in molar ratio) | 5.0% by weight |
| Citric acid | 0.6% by weight |
| Polyethylene glycol (weight average molecular weight: 1000) | 0.6% by weight |
| Water | 93.8% by weight |

By using Trendsetter 3244F (a plate setter manufactured by Creo Products Inc.; output: 9.0 W, revolution speed: 150 rpm, resolution: 2400 dpi, and image area: about 20%), planographic printing plates 2 (650 mm × 550 mm and thickness of 0.24 mm) were subjected to exposure and development processings (50 plates a day). The development processing was carried out for 60 days.

Every day, at the beginning of the processings, stepwise exposure was carried out in the same way as in Example 1 by using the original pattern of the Trendsetter 3244F. Clear sensitivity and solid sensitivity were respectively determined by using this original pattern.

On the first day of the processings, solid sensitivity was 40 mJ/cm², and clear sensitivity was 71 mJ/cm².

Therefore, when solid sensitivity was outside the range of 35 to 45 mJ/cm² and clear sensitivity was outside the range of 59 to 84 mJ/cm², the temperature of the alkaline developer was changed so that the solid sensitivity and clear sensitivity fell in the respective ranges.

In accordance with the developer control method of the present invention, a development processing was carried out in a stable manner for 60 days. On the 14th day of the processings, clear sensitivity decreased to 87 mJ/cm², which was lower than the initially set exposure amount. Therefore, based on the control method of the present invention, feedback was performed in the same way as that performed in Example 1, and the electric conductivity of the alkaline developer which had been set to 45.0 ms/cm was increased by 4.0% to 46.8 ms/cm. By this adjustment, clear sensitivity fell within the standard range. When printing was performed by using the obtained planographic printing plates, printing matter having good quality was obtained in which image portions had a satisfactory density and non-image portions had no coloring or stains.

Further, on the 32nd day, clear sensitivity increased to 57 mJ/cm², which was higher than the initially set exposure amount. Therefore, based on the control method of the present invention, feedback was performed in the same way as that performed in Example 1, and the electric conductivity of the alkaline developer set was decreased by 4.0% to 45.0 ms/cm. By this adjustment, clear sensitivity fell within the standard range. When printing was performed by using the obtained planographic printing plates, printing matter having good quality was obtained in which image portions had a satisfactory density and non-image portions had no coloring or stains.

If the control method of the present invention had not been used, the automatic developing machine would have been in operating condition for only 14 days. Therefore, it can be seen that the control method of the present invention is effective.

### Example 3

On the planographic printing plates similar to those used in Example 2, exposure and development processings were continuously carried out under the same conditions as those of Example 2, and the quality control method of the present invention was applied.

In accordance with the developer control method of the present invention, a development processing was carried out in a stable manner for 60 days. On the 25th day of the processing, clear sensitivity decreased to 87 mJ/cm², which was lower than the initially set exposure amount. Therefore, based on the control method of the present invention, feedback was performed in such a way that the initially set electric conductivity (45.0 ms/cm) of the alkaline developer was increased by 2.0% to 45.9 ms/cm and the temperature of the alkaline developer was increased by 2.0% to 30.6°C. By this adjustment, clear sensitivity fell within the standard range. When printing was performed by using the obtained planographic printing plates, printing matter having good quality was obtained in which image portions had a satisfactory density and non-image portions had no coloring or stains.

Further, on the 40th day, clear sensitivity increased to 57 mJ/cm², which was higher than the initially set exposure amount. Therefore, based on the control method of the present invention, feedback was performed in such a way that the electric conductivity which had been set to 45.9 ms/cm was decreased by 2.0% to 45.0 ms/cm and the temperature of the developer (30.6°C) was decreased by 2.0% to 30.0°C. By this adjustment, clear sensitivity fell within the standard range. When printing was performed by using the obtained planographic printing plates, printing matter having good quality was obtained in which image portions had a satisfactory density and non-image portions had no coloring or stains.

If the control method of the present invention had not been used, the automatic developing machine would have been in operating condition for only 25 days. Therefore, it can be seen that the control method of the present invention is effective.

### Example 4

On the planographic printing plates similar to those used in Example 2, exposure and development processings were continuously carried out under the same conditions as those of Example 2, and the quality control method of the present invention was applied.

In accordance with the developer control method of the present invention, a development processing was carried out in a stable manner for 60 days. On the 20th day of the processings, clear sensitivity decreased to 87 mJ/cm², which was lower than the initially set exposure amount. Therefore, based on the control method of the present invention, feedback was performed in such a way that the initially set electric conductivity (45.0 ms/cm) of the alkaline developer was increased by 2.0% to 45.9 ms/cm and the development processing time (12.0 seconds) of the alkaline developer was increased by 5% to 12.6 seconds. By this adjustment, clear sensitivity fell within the standard range. When printing was performed by using the obtained planographic printing plates, printing matter having good quality was obtained in which image portions had a satisfactory density and non-image portions had no coloring or stains.

Further, on the 45th day, clear sensitivity increased to 57 mJ/cm², which was higher than the initially set exposure amount. Therefore, based on the control method of the present invention, feedback was performed in such a way that the electric conductivity which had been set to 45.9 ms/cm was decreased by 2.0% to 45.0 ms/cm and the development processing time of the developer (12.6 seconds) was decreased by 5% to 12.0 seconds. By this adjustment, clear sensitivity fell within the standard range. When printing was performed by using the obtained planographic printing plates, printing matter having good quality was obtained in which image portions had a satisfactory density and non-image portions had no coloring or stains.

If the control method of the present invention had not been used, the automatic developing machine would have been in operating condition for only 20 days. Therefore, it can be seen that the control method of the present invention is effective.

### Example 5

On the planographic printing plates similar to those used in Example 2, exposure and development processings were continuously carried out under the same conditions as those of Example 2, and the quality control method of the present invention was applied. Specifically, the electric conductivity at the time of clear sensitivity being changed by 20% (i.e., 59 to 84 mJ/cm) was set to 45.0 (ms/cm) ± 4%. A program was set up in which, when the electric conductivity became less than 43.2 ms/cm, the replenishing solution whose electric conductivity was higher than that of the developer was replenished into the development tank, and, when the electric conductivity exceeded 46.8 ms/cm, water was filled into the development tank. This program was set for the automatic developing machine, and the processings were carried out.

In accordance with the developer control method of the present invention, a development processing was carried out in a stable manner for 60 days. On the 20th day of the processing, clear sensitivity became 57.0 mJ/cm². A predetermined replenishing solution was supplied to the development tank, and, as a result, the electric conductivity of the alkaline developer became 45.0 ms/cm. By this adjustment, clear sensitivity fell within the standard range. When printing was performed by using the obtained planographic printing plates, printing matter having good quality was obtained in which image portions had a satisfactory density and non-image portions had no coloring or stains.

Further, on the 41st day, clear sensitivity became 85.2 mJ/cm². Therefore, water was supplied to the development tank, and, as a result, the electric conductivity of the alkaline developer became 45.0 ms/cm. By this adjustment, clear sensitivity fell within the standard range. When printing was performed by using the obtained planographic printing plates, printing matter having good quality was obtained in which image portions had a satisfactory density and non-image portions had no coloring or stains.

If the control method of the present invention had not been used, the automatic developing machine would have been in operating condition for only 20 days. Therefore, it can be seen that the control method of the present invention is effective.

In accordance with the present invention, by determining the plate-making conditions for a positive image forming material for an infrared laser and for direct plate production, particularly the active state of a developer, and feeding back the results of determination to a developing process, it is possible to provide a quality control method for maintaining the quality of a planographic printing plate constant and forming uniform images continuously.

## Claims

1. A quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of:
(A) preparing a standard alkaline developer and determining the activity of the standard alkaline developer by using a predetermined index;
(B) measuring the activity of an alkaline developer to be evaluated by using the same index as that used to determine the activity of the standard alkaline developer; and
(C) comparing the activity of the alkaline developer to be evaluated with that of the standard alkaline developer, and, as a result, when the difference between the activities of the two developers exceeds a predetermined value, adjusting the electric conductivity of the alkaline developer to be evaluated in accordance with the difference.

2. A quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of:
(A) preparing a standard alkaline developer and determining the activity of the standard alkaline developer by using a predetermined index;
(B) measuring the activity of an alkaline developer to be evaluated by using the same index as that used to determine the activity of the standard alkaline developer; and
(C) comparing the activity of the alkaline developer to be evaluated with that of the standard alkaline developer, and, as a result, when the difference between the activities of the two developers exceeds a predetermined value, adjusting the value of (e-e⁰)²×(t-t⁰)², wherein e is the electric conductivity of the alkaline developer to be evaluated, e⁰ is the electric conductivity of the standard alkaline developer, t is the temperature of the alkaline developer to be evaluated, and t⁰ is the temperature of the standard alkaline developer, in accordance with the difference so that the value falls within a range having a radius of 1.40.

3. A quality control method for a planographic printing plate produced by subjecting an image forming material to a development processing with an alkaline developer, the image forming material having a support and a photosensitive layer thereon containing an alkaline water-soluble resin and a compound which absorbs light and generates heat, the method comprising the steps of:
(A) preparing a standard alkaline developer and determining the activity of the standard alkaline developer by using a predetermined index;
(B) measuring the activity of an alkaline developer to be evaluated by using the same index as that used to determine the activity of the standard alkaline developer; and
(C) comparing the activity of the alkaline developer to be evaluated with that of the standard alkaline developer, and, as a result, when the difference between the activities of the two developers exceeds a predetermined value, adjusting the value of (e-e⁰)²×(s-s⁰)², wherein e is the electric conductivity of the alkaline developer to be evaluated, e⁰ is the electric conductivity of the standard alkaline developer, s is development processing time, and s⁰ is the initial processing time for the standard alkaline developer, in accordance with the difference so that the value falls within a range having a radius of 2.00.

4. The method according to any of claims 1 to 3, wherein the standard alkaline developer is an unused alkaline developer at the beginning of a development processing, and the alkaline developer to be evaluated is an alkaline developer which has been continuously used in a predetermined development processing.

5. The method according to any of claims 1 to 3, wherein the activity of the alkaline developer to be evaluated is measured by using as the index the state of an image portion or a non-image portion of a planographic printing plate for evaluation under predetermined exposure conditions, the planographic printing plate for evaluation having been subjected to exposure under a plurality of conditions while the plate surface energy is changed in steps.

6. The method according to claim 5, wherein, at the time the activity of the alkaline developer to be evaluated is measured by using as the index the state of an image portion or a non-image portion of the planographic printing plate for evaluation under predetermined exposure conditions, the electric conductivity is changed in a range of 4% to 10% when the activity changes by 40% with respect to the standard value.
